# EUROPÄISCHE PATENTSCHRIFT

(11) **EP 0 442 001 B1**
(45) Veröffentlichungstag und Bekanntmachung des Hinweises auf die Patenterteilung: **27.09.1995**
(21) Anmeldenummer: 90102815.9
(22) Anmeldetag: 13.02.1990
(51) Int. Cl.: H03K 5/24, H03K 17/14, G05F 3/26

(54) **Komparatorschaltung**
Comparator circuit
Circuit comparateur

(43) Veröffentlichungstag der Anmeldung: 21.08.1991
(73) Patentinhaber: SIEMENS AKTIENGESELLSCHAFT, 80333 München (DE)
(72) Erfinder: Feldtkeller, Martin, Dipl.-Ing., D-8000 München 80 (DE)

(56) Entgegenhaltungen:
- DE-A- 2 712 350
- GB-A- 2 118 336
- US-A- 3 330 972
- US-A- 3 588 535
- PROCEED. IEEE, Band 65, Nr. 10, Oktober 1977, Seiten 1514-1515; S. POOKAIYAUDOM et al.: "Precise wide-dynamic range constant current ratio circuits"
- P.HOROWITZ and W.HILL: "The Art of Electronics", Cambridge University Press, 1980, Cambridge, GB; Seiten 67-68 und 80-83
- J.MARKUS: "Modern Electronic Circuit Reference Manual", McGraw-Hill, 1980, New York, US; Seite 3

## Beschreibung

Die Erfindung betrifft eine Komparatorschaltung gemäß dem Oberbegriff des Anspruchs 1.

Aus "Modern Electronic Circuits Reference Manual", 1980, McGraw-Hill, New York, Seite 3 von J.MARKUS und aus der US-A-3 588 535 sind zum einen eine derartige Komparatorschaltung sowie Maßnahmen zur Temperaturkompensation bekannt.

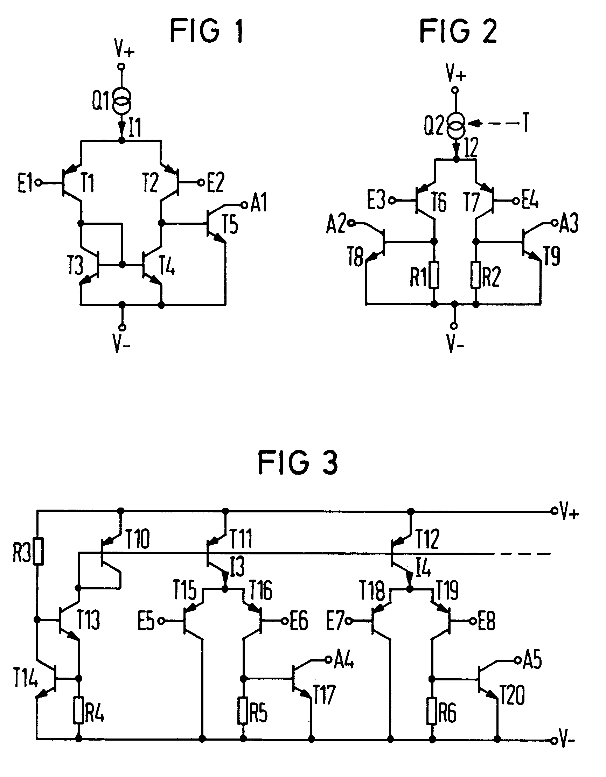

In analogen integrierten Schaltungen werden häufig Komparatoren verwendet, um zwei Spannungen miteinander zu vergleichen. Das Ergebnis dieses Vergleichs wird am Ausgang des Komparators durch einen bestimmten Schaltzustand angezeigt. Die Grundzelle eine Komparators besteht gemäß Figur 1 der Zeichnung beispielsweise aus zwei emittergekoppelten pnp-Transistoren T1 und T2, an deren Basen Eingangssignale E1 und E2 als gegenüber einem Referenzpotential auftretende Spannungen anliegen, aus einem zwei npn-Transistoren T3 und T4 aufweisendem Stromspiegel, dessen Fußpunkt mit dem negativen Pol V- der Versorgungsspannungsquelle und dessen Eingang bzw. Ausgang jeweils mit dem Kollektor eines der beiden Transistoren T1 und T2 verbunden ist, aus einem npn-Transistor T5, dessen Basis mit dem Ausgang des Stromspiegels und dessen Emitter mit dem negativen Pol V- der Versorgungsspannungsquelle verbunden ist und aus einer Stromeinprägung Q1, die zwischen den positiven Pol V+ der Versorgungsspannungsquelle und den gekoppelten Emittern der Transistoren T1 und T2 geschaltet ist. Der Kollektor des Transistors T5, dessen Schaltzustand als Ausgangssignal A1 das Vergleichsergebnis darstellt, ist dabei ebenso wie die Basen der Transistoren T1 und T2 gegebenenfalls mit weiteren Schaltelementen gekoppelt. Der von der Stromeinprägung Q1 eingeprägte Strom I1 ist im wesentlichen konstant und von der Temperatur abhängig.

Aufgrund der endlichen Steilheit der Transistoren T1 und T2 ist der Übergang des Transistors T5 vom leitenden zum gesperrten Zustand in dem Bereich, in dem die Spannungen der Eingangssignale E1 und E2 ungefähr gleich sein, fließend. Deshalb ist an der Basis des Transistors T5 eine Last erforderlich, die an der Basis des Transistors T5 eine Spannung in Höhe der typischen Basis-Emitter-Schwellspannung dann zuläßt, wenn der Kollektorstrom des Transistors T2 größer ist als der Kollektorstrom des Transistors T1. Als derartige Last wird bei Komparatorschaltungen üblicherweise ein Stromspiegel verwendet. Eine gebräuchliche Komparatorschaltung ist beispielsweise aus LP 265/LP 365 Mikropower Programmable Quad Comparator, Linear Databook 1, National Semiconductor Corporation, Santa Clara, USA, S. 4-67ff bekannt. Werden nun in einer integrierten Schaltung mehrere Komparatoren benötigt, so stellt der Stromspiegel mit seinen beiden Transistoren einen erheblichen Schaltungsaufwand dar.

Aufgabe der Erfindung ist es daher, eine Komparatorschaltung mit geringerem Aufwand anzugeben.

Diese Aufgabe wird durch eine Komparatorschaltung gemäß Patentanspruch 1 gelöst. Ausgestaltungen und Weiterbildungen des Erfindungsgedankens sind in Unteransprüchen gekennzeichnet.

Die Erfindung wird nachfolgend anhand der in den Figuren der Zeichnung dargestellten Ausführungsbeispiele näher erläutert. Es zeigt:
- FIG 1: eine bekannte Komparatorschaltung,
- FIG 2: eine allgemeine Ausführungsform des Prinzips der erfindungsgemäßen Komparatorschaltung und
- FIG 3: eine Ausführungsform mit mehreren Komparatorschaltungen mit der erfindungsgemäßen Ausführungsform der Stromeinprägung.

In dem Ausführungsbeispiel nach FIG 2 weist die erfindungsgemäße Komparatorschaltung zwei emittergekoppelte pnp-Transistoren T6 und T7 auf. An die Basis des Transistors T6 ist ein Eingangssignal E3 und an die Basis des Transistors T7 ein Eingangssignal E4 gelegt. Bei den beiden Eingangssignalen E3, E4 handelt es sich dabei um Spannungen. Die Kollektoren beider Transistoren sind jeweils über einem Widerstand R1 bzw. R2 mit dem negativen Pol V- einer in der Zeichnung nicht näher dargestellten Versorgungsspannungsquelle verbunden. Die beiden Widerstände R1 und R2 sind dabei identisch aufgebaut, so daß sie einen gleichen Widerstandswert und einen gleichen Temperaturgang aufweisen. Den Widerständen R1 und R2 sind jeweils die Basis-Emitter-Strecken zweier npn-Transistoren T8 und T9 parallel geschaltet. Der das Vergleichsergebnis repräsentierende Schaltzustand der Transistoren T8 und T9 ist als Signal A2 bzw. A3 an dem Kollektor des jeweiligen Transistors abgreifbar. Die gekoppelten Emitter der Transistoren T6 und T7 sind über eine Stromeinprägung Q2 mit dem positiven Pol V+ der Versorgungsspannungsquelle verbunden. Über den Wert des von der Stromeinprägung Q2 eingeprägten Stromes I2 und dessen Abhängigkeit von der Temperatur T wird an anderer Stelle noch näher eingegangen.

Das Ausführungsbeispiel gemäß FIG 3 zeigt eine Ausführungsform mit mehreren Komparatoren, wobei jedoch nur zwei in der Zeichnung dargestellt sind. Diese weisen jeweils zwei emittergekoppelte pnp-Transistoren T15, T16; T18, T19 auf, an deren Basen jeweils Eingangssignale E5 bis E8 gelegt sind. In die Kollektorleitung jeweils eines Transistors T16; T19 sind Widerstände R5; R6 geschaltet, denen die Basis-Emitter-Strecke jeweils eines npn-Transistors T17; T20 parallel liegt. Die Emitter der Transistoren T17; T20 sind ebenso wie die Kollektoren der jeweils anderen Transistoren T15; T18 der emittergekoppelten Transistoren mit dem negativen Pol V- der Versorgungsspannungsquelle verbunden. Die Kollektoren der Transistoren T16; T19 führen Ausgangssignale A4 und A5. Die gekoppelten Emitter der Transistoren T15, T16; T18, T19 sind jeweils über die Emitter-Kollektor-Strecke eines pnp-Transistors T11; T12 mit dem positiven Pol V+ der Versorgungsspannungsquelle verbunden. Die gekoppelten Basen der Transistoren T11; T12 sind mit der Kathode einer auf den positiven Pol V+ der Versorgungsspannung führenden Diode verschaltet. Die Diode wird im vorliegenden Ausführungsbeispiel durch einen pnp-Transistor T10 gebildet, dessen Basis und dessen Kollektor miteinander verbunden sind. Die Kathode dieser Diode ist zudem über die Kollektor-Emitter-Strecke eines npn-Transistors T13 und einen Widerstand R4 mit dem negativen Pol V- der Versorgungsspannungsquelle gekoppelt. Dem Widerstand R4 liegt die Basis-Emitter-Strecke eines npn-Transistors T14 parallel, dessen Kollektor mit der Basis des Transistors T13 und einem auf den positiven Pol V+ der Versorgungsspannungsquelle führenden Widerstand R3 verschaltet ist. Der durch den Transistor T10 gebildeten Diode sind die Basis-Emitter-Strecken weiterer pnp-Transistoren parallelgeschaltet, die Stromeinprägungen für weitere, in der Zeichnung nicht näher dargestellte Komparatoren bilden. Alle Komparatoren sind dabei ebenso wie die Stromeinprägungen identisch aufgebaut. Jedoch ist in gleichem Maße ein voneinander abweichender Aufbau möglich. Dazu ist jedoch eine Anpassung beispielsweise über die jeweils die Stromeinprägungen bildenden Transistoren notwendig.

Die Funktionsweise einer erfindungsgemäßen Komparatorschaltung beruht auf folgenden Überlegungen: Ein sehr einfacher Komparator verwendet als Last statt einem Stromspiegel lediglich einen ohmschen Widerstand zwischen Emitter und Basis des Ausgangsschalttransistors - im vorliegenden Ausführungsbeispiel sind dies beispielsweise die Transistoren T8, T9, T17, T20. Damit der Komparator bei Gleichheit der Eingangssignalspannungen schaltet, muß der Lastwiderstand - im vorliegenden Ausführungsbeispiel sind dies die Widerstände R1, R2, R5, R6 - unter Berücksichtigung dessen, daß in diesem Falle die Kollektorströme der beiden emittergekoppelten Transistoren jeweils gleich dem halben, durch die Stromeinprägung eingeprägten Strom sind, so dimensioniert werden, daß der jeweilige Lastwiderstand gleich der Emitter-Basis-Schwellspannung des jeweiligen Ausgangsschalttransistors geteilt durch den halben, eingeprägten Strom ist. Da die Emitter-Basis-Schwellspannung eines Transistors mit zunehmender Temperatur abfällt, Widerstände in integrierten Schaltungen aber einen positiven Temperaturkoeffizienten aufweisen, d. h. mit zunehmender Temperatur einen zunehmenden Widerstand aufweisen, wäre die Schaltschwelle dieses einfachen Komparators sehr stark temperaturabhängig. Erfindungsgemäß wird nun der eingeprägte Strom der Komparatoren - im Ausführungsbeispiel sind dies der Strom I2 sowie die Kollektorströme I3 und I4 der Transistoren T11 und T12 - mit der Temperatur so geführt, daß der Komparator temperaturunabhängig bei Gleichheit der Eingangssignalspannungen schaltet. Der eingeprägte Strom ist erfindungsgemäß nun gleich dem doppelten Quotienten aus der temperaturabhängigen Emitter-Basis-Schwellspannung des Ausgangsschalttransistors und aus dem temperaturabhängigen Lastwiderstand und weist die gleiche Temperaturabhängigkeit auf. Dabei kann bei der Realisierung der Stromeinprägung in guter Näherung für gleich aufgebaute Transistoren und gleich aufgebaute Widerstände ein identisches Temperaturverhalten angenommen werden. Für die davon ausgehende und in FIG 3 gezeigte Ausführungsform einer temperaturabhängigen Stromeinprägung ergibt sich für den Widerstand R4 ein Wert der gleich dem halben Wert des Lastwiderstandes, also des Wertes des Widerstandes R5 bzw. R6, ist. Dieser halbe Widerstandswert läßt sich leicht, beispielsweise durch Parallelschalten zweier identisch mit dem Lastwiderstand (also dem Widerstand R5 bzw. R6) aufgebauter Widerstände erzielen.

Der schaltungstechnische Aufwand ist bei einer erfindungsgemäßen Komparatorschaltung wesentlich geringer als bei bekannten. Der Ersatz des Stromspiegels, der immerhin zwei Transistorstrukturen benötigt, durch einen leicht realisierbaren, aufwandsarmen Widerstand in der integrierten Schaltung verringert den Platzbedarf in der integrierten Schaltung wesentlich, zumal sich der Aufwand für die temperaturabhängige Stromeinprägung gegenüber den bisher gebräuchlichen, temperaturunabhängigen Stromeinprägungen nicht erhöht.

## Patentansprüche

1. Komparatorschaltung mit einem ersten und zweiten Transistor (T6, T7; T15, T16; T18, T19) des einen Leitungstyps, an deren Basen Eingangssignale (E3, E4; E5, E6; E7, E8) angelegt sind und deren Kollektoren mit einem ersten Pol (V-) einer Versorgungsspannungsquelle verbunden sind,
mit einem ersten Widerstand (R2; R5, R6), der in die Kollektorleitung eines (T7, T16, T19) der beiden Transistoren des einen Leitungstyps geschaltet ist,
mit einem ersten Transistor (T9, T17; T20) des anderen Leitungstyps, dessen Basis-Emitter-Strecke dem ersten Widerstand (R2; R5, R6) parallel geschaltet ist und an dessen Kollektor ein Ausgangssignal (A3; A4, A5) anliegt,
**dadurch gekennzeichnet**,
daß eine Stromeinprägung (Q2; T10...T14, R3 R4) vorgesehen ist, die zwischen die gekoppelten Emitter von erstem und zweitem Transistor (T6, T7; T15, T16; T18, T19) des einen Leitungstyps und einem zweiten Pol (V+) der Versorgungsspannungsquelle geschaltet ist, wobei der durch die Stromeinprägung (Q2; T10...T14, R3, R4) eingeprägte Strom (I2; I3, I4) bei jeder Betriebstemperatur gleich dem doppelten Quotienten aus der Basis-Emitter-Spannung im Schaltpunkt des ersten Transistors (T9; T17, T20) des anderen Leitungstyps und des ersten Widerstands (R2; R5, R6) ist und wobei als Stromeinprägung ein dritter Transistor (T11,T12) des einen Leitungstyps vorgesehen ist, dessen Emitter mit dem zweiten Pol (V+) der Versorgungsspannungsquelle und dessen Kollektor mit den gekoppelten Emittern von erstem und zweitem Transistor (T6, T7; T15, T16, T18, T19) des einen Leitungstyps verbunden ist,
daß die Basis des dritten Transistors (T11,T12) des einen Leitungstyps zum einen über eine Diode (T10) in Durchlaßrichtung mit dem zweiten Pol (V+) der Versorgungsspannungsquelle und zum anderen über die Kollektor-Emitter-Strecke eines zweiten Transistors (T13) des anderen Leitungstyps und einen zweiten Widerstand (R4) mit dem ersten Pol (V-) der Versorgungsspannungsquelle verbunden ist,
daß die Basis des zweiten Transistors (T13) des anderen Leitungstyps zum einen über einen dritten Widerstand (R3) mit dem anderen Pol (V+) der Versorgungsspannungsquelle und zum anderen über die Kollektor-Emitter-Strecke eines dritten Transistors (T14) des anderen Leitungstyps mit dem einen Pol (V-) der Versorgungsspannungsquelle verbunden ist und daß die Basis-Emitterstrecke des dritten Transistors (T14) des anderen Leitungstyps dem zweiten Widerstand (R4) parallel geschaltet ist.

2. Komparatorschaltung nach Anspruch 1,
**dadurch gekennzeichnet,**
daß ein vierter Widerstand (R1) mit gleichem Widerstandswert und gleichem Temperaturverhalten wie der erste Widerstand (R2) in die Kollektorleitung des anderen Transistors (T6) des einen Leitungstyps geschaltet ist und
daß dem vierten Widerstand (R1) die Basis-Emitter-Strecke eines vierten Transistors (T8) des anderen Leitungstyps mit gleicher Basis-Emitter-Spannung und gleichem Temperaturverhalten wie der erste Transistor (T9) des anderen Leitungstyps parallel geschaltet ist, an dessen Kollektor ein weitereres Ausgangssignal (A2) anliegt.

3. Komparatorschaltung nach einem der Ansprüche 1 oder 2,
**dadurch gekennzeichnet**,
daß die Basis-Emitter-Strecken weiterer Transistoren (T12) des einen Leitungstyps der Basis-Emitter-Strecke des dritten Transistors (T11) des einen Leitungstyps parallelgeschaltet sind, wobei die weiteren Transistoren (T12) als Stromeinprägungen weiterer Komparator-Schaltungen (T18, T19, T20, R6) vorgesehen sind.

## Claims

1. Comparator circuit having a first and a second transistor (T6, T7; T15, T16; T18, T19) of one conductivity type to whose bases input signals (E3, E4; E5, E6; E7, E8) are applied and whose collectors are connected to a first terminal (V-) of a supply voltage source, having a first resistor (R2; R5, R6) which is connected into the collector lead (T7, T16, T19) of the two transistors of the one conductivity type, and having a first transistor (T9, T17; T20) on the other conductivity type whose base -emitter paths are or is connected in parallel with the first resistor (R2; R5, R6) and to whose collector an output signal (A3; A4, A5) is applied, characterized in that a current-impressing means (Q2,; T10...T14, R3, R4) is provided which is connected between the coupled emitters of the first and second transistors (T6, T7; T15, T16; T18, T19) of the one conductivity type and a second terminal (V+) of the supply voltage source, the current (I2; I3, I4) impressed by the current-impressing means (Q2; T10...T14, R3, R4) being equal for each operating temperature to twice the quotient of the base-to-emitter voltage at the operating point of the first transistor (T9; T17, T20) of the other conductivity type and the first resistor (R2; R5, R6), and the current-impressing means being provided as a third transistor (T11, T12) of the one conductivity type whose emitter is connected to the second terminal (V+) of the supply voltage source and whose collector is connected to the coupled emitters of the first and second transistor (T6, T7; T15, T16, T18 or T19) on the one conductivity type, in that the base of the third transistor (T11, T12) of the one conductivity type is, on the one hand, connected via a diode (T10) in the conducting direction to the second terminal (V+) of the supply voltage source and, on the other hand, is connected via the collector-to-emitter path of a second transistor (T13) of the other conductivity type and via a second resistor (R4) to the first terminal (V-) of the supply voltage source, in that the base of the second transistor (T13) of the other conductivity type is connected, on the one hand, via a third resistor (R3) to the other terminal (V+) of the supply voltage source and is connected, on the other hand, via the collector-to-emitter path of a third transistor (T14) of the other conductivity type to the one terminal (V-) of the supply voltage source, and in that the base-to-emitter path of the third transistor (T14) of the other conductivity type is connected in parallel with the second resistor (R4).

2. Comparator circuit according to Claim 1, characterized in that a fourth resistor (R1) having the same resistance value and the same temperature response as the first resistor (R2) is connected into the collector lead of the other transistor (T6) of the one conductivity type, and in that there is connected in parallel with the fourth resistor (R1) the base-to-emitter path of a fourth transistor (T8) of the other conductivity type having the same base-to-emitter voltage and the same temperature response as the first transistor (T9) of the other conductivity type to whose collector a further output signal (A2) is applied.

3. Comparator circuit according to one of Claims 1 or 2, characterized in that the base-to-emitter paths of further transistors (T12) of the one conductivity type are connected in parallel with the base-to-emitter path of the third transistor (T11) of the one conductivity type, the further transistors (T12) being provided as current-impressing means of further comparator circuits (T18, T19, T20, R6).

## Revendications

1. Circuit comparateur comportant des premier et second transistors (T6,T7; T15,T16; T18,T19) d'un premier type de conduction, aux bases desquels sont appliqués des signaux d'entrée (E3,E4; E5,E6; E7,E8) et dont les collecteurs sont reliés à un premier pôle (V-) d'une source de tension d'alimentation,
une première résistance (R2;R5,R6), qui est branchée dans la ligne du collecteur de l'un (T7,T16,T19) des deux transistors du premier type de conduction,
un premier transistor (T9,T17;T20) du second type de conduction et dont la section base-émetteur est branchée en parallèle avec la première résistance (R2;R5,R6) et au collecteur duquel est appliqué un signal de sortie (A3;A4,A5),
caractérisé par le fait
qu'il est prévu un circuit d'injection de courant (Q2; T10...T14, R3, R4), qui est branché entre les émetteurs couplés de premier et second transistors (T6,T7; T15,T16; T18,T19) du premier type de conduction et un second pôle (V+) de la source de tension d'alimentation, le courant (I2;I3,I4) injecté par le circuit d'injection de courant (Q2; T10...T14, R3, R4) étant, pour chaque température de fonctionnement, égal au double du quotient de la tension base-émetteur au point de commutation du premier transistor (T9;T17,T20) du second type de conduction, par la première résistance (R2;R5,R6), tandis qu'il est prévu, comme circuit d'injection de courant, un troisième transistor (T11,T12) du premier type de conduction, dont l'émetteur est relié au second pôle (V+) de la source de tension d'alimentation et dont le collecteur est relié aux émetteurs couplés de premier et second transistors (T6,T7; T15,T16; T18,T19) du premier type de conduction,
que la base du troisième transistor (T11,T12) du premier type de conduction est reliée d'une part dans le sens passant par l'intermédiaire d'une diode (T10) au second pôle (V+) de la source de tension d'alimentation et d'autre part par l'intermédiaire de la voie collecteur-émetteur d'un second transistor (T13) du second type de conduction et d'une seconde résistance (R4), au premier pôle (V-) de la source de tension d'alimentation,
que la base du second transistor (T13) du second type de conduction est reliée d'une part par l'intermédiaire d'une troisième résistance (R3) à l'autre pôle (V+) de la source de tension d'alimentation et d'autre part, par l'intermédiaire de la voie collecteur-émetteur d'un troisième transistor (T14) du second type de conduction, à un pôle (V-) de la source de tension d'alimentation, et
que la voie base-émetteur du troisième transistor (T14) du second type de conduction est branchée en parallèle avec la seconde résistance (R4).

2. Circuit comparateur suivant la revendication 1,
caractérisé par le fait
qu'une quatrième résistance (R1) ayant la même valeur résistive et le même comportement en température que la première résistance (R2) est branchée dans la ligne de collecteur de l'autre transistor (T6) du premier type de conduction, et
en parallèle avec la quatrième résistance (R1) est branchée la voie base-émetteur d'un quatrième transistor (T8) du second type de conduction, qui présente la même tension base-émetteur et le même comportement en température que le premier transistor (T9) du second type de conduction et sur le collecteur duquel est présent un autre signal de sortie (A2).

3. Circuit comparateur suivant l'une des revendications 1 ou 2, caractérisé par le fait que les voies base-émetteur d'autres transistors (T12) du premier type de conduction sont branchées en parallèle avec la voie base-émetteur du troisième transistor (T11) du premier type de conduction, les autres transistors (T12) étant prévus en tant que circuits d'injection de courant d'autres circuits comparateurs (T18,T19,T20,R6).
